# EUROPÄISCHE PATENTSCHRIFT

(11) **EP 2 921 853 B1**
(45) Veröffentlichungstag und Bekanntmachung des Hinweises auf die Patenterteilung: **28.09.2016**
(21) Anmeldenummer: 15158624.5
(22) Anmeldetag: 11.03.2015
(51) Int. Cl.: G01N 27/90, H03K 17/95

(54) **INDUKTIVER FOLIENDETEKTOR**
INDUCTIVE FOIL DETECTOR
DÉTECTEUR INDUCTIF DE FEUILLE

(30) Priorität: 18.03.2014 DE 102014103670
(43) Veröffentlichungstag der Anmeldung: 23.09.2015
(73) Patentinhaber: SICK AG, 79183 Waldkirch/Breisgau (DE)
(72) Erfinder: Dorer, Armin, 78120 Furtwangen (DE); Hall, Thomas, 79215 Elzach (DE); Wegner, Börge, 79426 Buggingen (DE)
(74) Vertreter: Manitz, Finsterwald & Partner GbR

(56) Entgegenhaltungen:
- EP-A2- 0 125 386
- EP-A2- 1 959 570
- US-A1- 2013 064 635
- US-B1- 6 437 560

## Beschreibung

Die Erfindung betrifft einen induktiven Foliendetektor zur Detektion der Anzahl von aneinander liegenden Folien, die jeweils ein Grundmaterial und eine daran angeordnete, elektrisch leitfähige Schicht umfassen. Die Erfindung betrifft weiterhin eine Greifeinrichtung für solche Folien von einem Stapel mit einem solchen induktiven Foliendetektor. Weiterhin betrifft die Erfindung ein Verfahren zur Bestimmung der Anzahl von solchen aneinander liegenden Folien.

Zum Beispiel bei der Herstellung von Akkumulatoren werden beschichtete Folien als Anode und Kathode eingesetzt. Solche Folien werden in der Regel mit einem Vakuum-Greifer aus einem sortenreinen Stapel gehoben und auf einer Stapelposition in der Reihenfolge Anode, Separator, Kathode, Separator, Anode, Separator, Kathode, ... platziert. Dabei sollte immer genau eine Folie vom Stapel entnommen werden. Wenn es passiert, dass beim Greifen keine Folie gegriffen wird, oder gleich mehrere Folien (typischerweise z.B. zwei), die aneinander anhaften, wird eine undefinierte Situation in der Maschine herbeigeführt.

Gerade bei automatisierten Fertigungslinien für Akkumulatoren ist dies im Hinblick auf die gewünschten größeren Mengen und geringen Kosten kritisch.

Bekannte Anordnungen umfassen Vakuumgreifer mit biegsamer Greiferfläche. In einem ersten Schritt wird die oberste Folie mit dem Greifer von dem sortenreinen Stapel angesaugt und anschließend gebogen. Diese Biegung bewirkt, dass sich eine gegebenenfalls vorhandene zweite Folie von der ersten Folie lösen soll und nicht mit angehoben wird.

Ob eine Folie abgegriffen worden ist, wird mit Hilfe eines Vakuumgrenzschalters an dem Vakuumgreifer detektiert. Eine sensorische Erkennung der Folien erfolgt mit analogen induktiven Sensoren. Ob tatsächlich nur eine Folie aufgegriffen worden ist, muss daher beim Stand der Technik unter Einsatz einer gegebenenfalls teuren Analogkarte anhand eines analogen Messsignals erfolgen.

Es sind, z.B. aus EP1959570, induktive Näherungssensoren bekannt, mit deren Hilfe der Abstand eines Objekts von dem Sensor aus der Bedämpfung des Schwingkreises durch das Objekt bestimmt wird. Eine Aussage über die Anzahl von einzelnen Folien ist dabei nicht vorgesehen.

Aufgabe der vorliegenden Erfindung ist es, einen induktiven Foliendetektor anzugeben, mit dem eine einfache und kostengünstige Auswertung und Weiterverarbeitung der Information möglich ist, insbesondere auch unter Einsatz einer speicherprogrammierbaren Steuerung (SPS).

Diese Aufgabe wird mit einem induktiven Foliendetektor mit den Merkmalen des Anspruchs 1, einer Greifeinrichtung mit den Merkmalen des Anspruchs 4 und einem Verfahren zur Bestimmung der Anzahl von aneinander liegenden Folien mit den Merkmalen des Anspruchs 5 gelöst. Unteransprüche sind auf bevorzugte Ausgestaltungen gerichtet.

Ein erfindungsgemäßer induktiver Foliendetektor dient zur Detektion der Anzahl von aneinander liegenden Folien, die jeweils ein, insbesondere schlecht leitendes oder isolierendes, Grundmaterial und eine daran angeordnete elektrisch leitfähige Schicht umfassen. Insbesondere kann es sich dabei z.B. um Anoden- und/oder Kathodenfolien zum Einsatz in Akkumulatoren handeln. Dabei bestehen die Folien beispielsweise aus Kupfer bzw. Aluminiumschichten auf schlecht leitendem oder isolierendem Anoden- bzw. Kathodenmaterial.

Der erfindungsgemäße induktive Foliendetektor weist einen Schwingkreis zur Erzeugung eines elektromagnetischen Wechselfeldes auf. Befindet sich in diesem von dem Schwingkreis erzeugten elektromagnetischen Wechselfeld eine Folie mit einer metallischen Schicht, so wird in dieser Folie durch das elektromagnetische Wechselfeld des Schwingkreises ein Wirbelstrom angeregt, der wiederum ein dem anregenden elektromagnetischen Wechselfeld des Schwingkreises entgegengesetztes Feld bewirkt. Der Schwingkreis wird dementsprechend durch die Anwesenheit der Folie bedämpft. Diese Bedämpfung kann in an sich bekannter Weise wie z.B. bei einem induktiven Näherungssensor bestimmt werden. Die Erfinder haben erkannt, dass z.B. aufgrund der geringen Materialstärke der Metallschicht beziehungsweise einer schlecht leitenden oder isolierenden Grundmaterialschicht, wie sie beispielsweise bei Akkumulatorfolien zum Einsatz kommen, das elektromagnetische Wechselfeld des induktiven Detektors eine Folie durchdringen kann und eine gegebenenfalls vorhandene zweite Folie erfassen kann. Das elektromagnetische Wechselfeld, das die erste Folie durchdringt, kann - geschwächt durch das von dem Wirbelstrom in der ersten Folie angeregten Magnetfeld - auf die zweite Folie wirken und dort ebenfalls einen Wirbelstrom erzeugen, der wiederum zu einem elektromagnetischen Gegenfeld führt. Bei Vorhandensein einer Folie ist die Bedämpfung daher größer als bei einer größeren Anzahl Folien. Erfindungsgemäß ist dazu eine Auswerteeinrichtung vorgesehen, mit der die Bedämpfung des Schwingkreises bestimmt werden kann, wobei die Auswerteeinrichtung derart ausgestaltet ist, dass sie bei Überschreiten eines ersten vorgegebenen Schwellwertes der Bedämpfung vom Vorhandensein einer einzelnen Folie in einem vorgegebenen Detektionsabstand ausgeht und ein entsprechendes Signal erzeugt, bei Unterschreiten des ersten Schwellwertes vom Vorhandensein zweier oder mehr Folien im vorgegebenen Detektionsabstand ausgeht und ein entsprechendes Signal erzeugt und bei Unterschreiten eines zweiten vorgegebenen Schwellwertes, der kleiner als der erste Schwellwert ist, von einem Zustand ohne Folien im Detektionsabstand ausgeht und ein entsprechendes Signal erzeugt.

Dabei kann der Detektionsabstand insbesondere z.B. dem Abstand entsprechen, der sich ergibt, wenn die Folie von einem Vakuumgreifer gehalten wird, an dem der erfindungsgemäße induktive Foliendetektor befestigt ist.

Grundsätzlich ist es auch möglich, dass der erste und der zweite Schwellwert gleich sind. Auf diese Weise kann durch Vergleich des Bedämpfungssignals mit dem Schwellwert festgestellt werden, ob dieser überschritten ist und insofern vom Vorliegen genau einer Folie im Detektionsabstands ausgegangen werden muss. Bei Unterschreiten des Schwellwertes liegen entweder zwei Folien oder keine Folie vor, weil das Bedämpfungssignal in beiden Fällen kleiner ist als das Bedämpfungssignal beim Vorhandensein von nur einer Folie. Trotzdem kann aus dem Über- bzw. Unterschreiten des Schwellwerts entschieden werden, ob ein gewünschter (genau eine Folie) oder ein nicht gewünschter (keine oder zwei oder mehr Folien) vorliegt, um entsprechende Maßnahmen im Prozess zu ergreifen.

Insbesondere eignet sich der erfindungsgemäße induktive Foliendetektor für Anoden- und/oder Kathodenfolien zum Einsatz in Akkumulatoren. In der Regel weisen diese eine wenige Mikrometer dicke Metallschicht (z.B. 10 bis 30 µm) auf, die sich auf einem ebenfalls wenige Mikrometer dicken Grundmaterial (z.B. 100 bis 200 µm Dicke) befindet. Es können aber auch andere Materialstärken vorliegen, solange der oben beschriebene Effekt der kleineren Bedämpfung des Schwingkreises bei größerer Folienanzahl erhalten bleibt. Das Grundmaterial ist zum Beispiel schlecht leitend oder isolierend, wie es bei Akkumulatorfolien der Fall ist.

Eine Kathodenfolie besteht dabei z.B. aus einer Aluminiumschicht auf einer Kathodenschicht. Eine solche Kathodenschicht kann (bei einem Li-Ionen-Akku) z.B. aus LiFeMnPO4 zur Aufnahme von Li+-Ionen beim Entladevorgang bestehen.

Eine Anodenfolie kann z.B. aus einer Kupferschicht auf einer Anodenschicht bestehen. Eine solche Anodenschicht kann dabei bei einem Li-Ionen-Akku z.B. aus künstlichem Graphitpulver zur Abgabe der Li+-Ionen beim Entladen dienen.

Zwischen Anodenfolie und Kathodenfolie befindet sich bei einem Akkumulator ein Elektrolyt bzw. Separator, der beim geschilderten Beispiel durchlässig für Li+-Ionen, aber elektrisch isolierend ist.

Gemäß einer besonders vorteilhaften Ausgestaltung ist die Auswerteeinrichtung derart ausgestaltet, dass sie ein Signal an einem Digitalausgang gibt, dessen Größe vom Über- bzw. Unterschreiten des ersten und/oder des zweiten Stellwertes abhängt. Ein solches digitales Ausgangssignal kann auf vorteilhafte und einfache Weise aus dem erfindungsgemäß stattfindenden Vergleich der Bedämpfung des Schwingkreises mit dem ersten bzw. dem zweiten Schwellwert erzeugt werden. In einem Hauptanwendungsfall, in dem festgestellt werden soll, ob eine, zwei oder keine Folie mit Hilfe eines Vakuumgreifers gehalten werden, kann z.B. ein Digitalausgang der Auswerteeinrichtung so ausgestaltet sein, dass drei unterschiedliche digitale Signale ausgegeben werden können, die dem Vorhandensein von keiner, einer bzw. zwei Folien entsprechen.

Ein solches Signal lässt sich besonders einfach durch eine speicherprogrammierbare Steuerung (SPS) verarbeiten. Mit der SPS kann dann z.B. eine Anzeige, ein Warnsignal oder ein Aktorsignal getriggert werden, das eine Anlage stoppt oder umlenkt, wenn weniger als eine oder mehr als eine Folie gegriffen worden sind.

Der induktive Foliendetektor kann eine Speichereinrichtung aufweisen, in der die relevanten Schwellwerte abgelegt sind. Dabei kann entweder genau ein Szenario durch entsprechende vorgegebene Schwellwerte behandelt werden (also z.B. in einer Anlage, in der immer dieselben Folien zum Einsatz kommen), wobei diese Schwellwerte in Abhängigkeit dieser Folien zuvor eingelernt werden. Bei anderen Ausgestaltungen des erfindungsgemäßen Foliendetektors kann auch eine Speichereinrichtung vorgesehen sein, in der mehrere unterschiedliche Folienmaterialien und die daraus resultierenden Schwellwerte abgelegt sind, die z.B. ebenfalls im Vorhinein für die unterschiedlichen Folien eingelernt worden sind. Bei einer solchen Ausgestaltung kann dann z.B. an einem entsprechenden Auswahlmenü eingestellt werden, welche Folien gerade verarbeitet werden.

Bei einem erfindungsgemäßen Verfahren kann ein erfindungsgemäßer induktiver Foliensensor zum Einsatz kommen. Eine unbekannte Folienanzahl wird in einen Detektionsabstand gebracht. Mit einem Schwingkreis wird ein elektromagnetisches Wechselfeld erzeugt und aus der Bedämpfung des Schwingkreises auf die Anzahl von Folien in dem vorgegebenen Detektionsabstand geschlossen, wobei bei einer größeren Bedämpfung von einer kleineren Anzahl Folien ausgegangen wird.

Nur bei einer minimalen Bedämpfung wird davon ausgegangen, dass keine Folie im Detektionsabstand vorhanden ist.

Die unbekannte Anzahl an Folien, die in den Detektionsabstand gebracht wird, ergibt sich z.B. dadurch, wie viele Folien ein Vakuumgreifer auf einmal greift. Idealerweise ist dies nur eine Folie, die auf den Stapel des zukünftigen Akkumulators gelegt werden soll. Wird keine oder werden zwei Folien gegriffen, so ist dies mit dem erfindungsgemäßen Verfahren feststellbar und es können die entsprechenden Maßnahmen ergriffen werden, dass kein fehlerhafter Aufbau des Akkumulators erfolgt.

Vorteilhafterweise wird dabei abgeprüft, ob sich die Bedämpfung des Schwingkreises oberhalb eines ersten Schwellwertes befindet und insofern davon ausgegangen wird, dass eine einzelne Folie vorhanden ist, oder ob ein zweiter Schwellwert unterschritten wird, so dass davon ausgegangen wird, dass keine Folie vorhanden ist, oder beim Unterschreiten des ersten Schwellwertes bzw. Überschreiten des zweiten Schwellwertes davon ausgegangen wird, dass zwei oder mehr Folien vorhanden sind.

Weitere Vorteile und Ausgestaltungen des erfindungsgemäßen Verfahrens ergeben sich aus der obigen Beschreibung der Vorteile und Ausgestaltungen des erfindungsgemäßen induktiven Foliensensors.

Sowohl der erfindungsgemäße induktive Foliendetektor als auch das erfindungsgemäße Verfahren können so ausgestaltet sein, dass auch andere Anzahlen als Null, eine oder zwei Folien erkannt werden können, wenn eine entsprechende Anzahl von Schwellwerten abgespeichert bzw. abgeprüft wird.

Die Erfindung wird anhand der beiliegenden Figuren im Detail erläutert. Dabei zeigen in schematischer Darstellung:
- Fig. 1: die Anordnung eines Vakuumgreifers oberhalb eines Folienstapels mit einem induktiven Foliendetektor,
- Fig. 2: eine schematische Darstellung einer zu greifenden Folie,
- Fig.3: die Anordnung der Fig. 1 während des Aufnehmens einer Folie,
- Fig. 4: ein Bedämpfungssignal in Abhängigkeit der Anzahl der aufgenommenen Folien, und
- Fig. 5: ein Detail einer Akkumulatoranordnung, die mit einem Vakuumgreifer der Fig. 1 bzw. 3 unter Einsatz eines erfindungsgemäßen induktiven Foliendetektors aufgebaut werden kann.

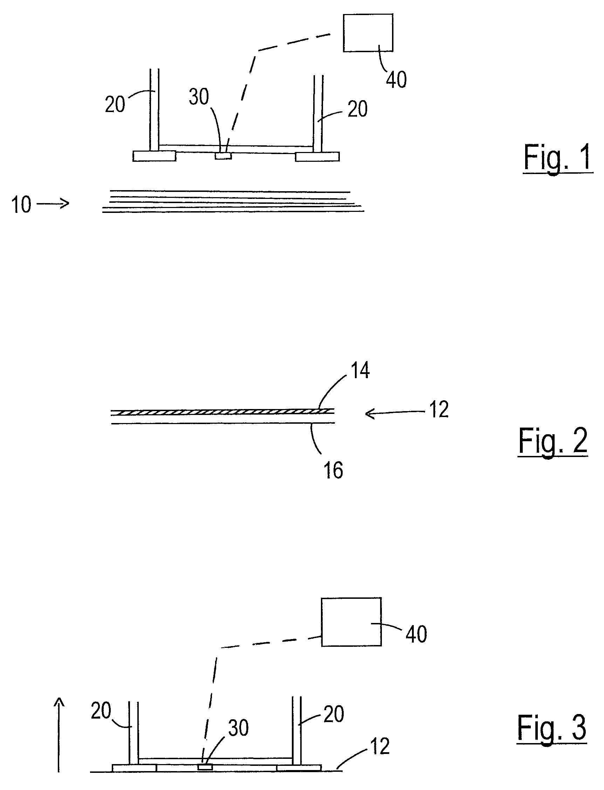

Fig. 1 zeigt einen Folienstapel 10, der z.B. aus Folien 12 besteht, wie sie in Fig. 2 gezeigt sind. Die Folien 12 umfassen eine leitfähige Elektrodenschicht 14 auf einem Grundmaterial 16. Es kann sich dabei z.B. um eine Aluminiumschicht 14 handeln, die als elektrisch leitende Folie für eine Kathode dient, die durch das Grundmaterial 16 gebildet wird.

Eine Vakuumgreifeinrichtung mit einzelnen Vakuumgreifern 20 dient zur Aufnahme von einzelnen Folien 12 des Stapels 12. Die Vakuumgreifeinrichtung weist einen induktiven Foliendetektor 30 auf, der zur Detektion der Anzahl von gegriffenen Folien dient, wie es weiter unten beschrieben werden wird. Das Signal des induktiven Foliendetektors 30 wird an eine Auswerteeinheit 40 gegeben, die ausgestaltet ist, die Anzahl der Folien zu bestimmen. In nicht gezeigter Weise kann die Auswerteeinheit 40 z.B. mit einer speicherprogrammierbaren Steuerung verbunden sein oder diese umfassen. Dort können dann in Abhängigkeit des Signales der Auswerteeinheit entsprechende Warnungen oder Steuerungssignale erzeugt werden.

Fig. 3 zeigt den Zustand, in dem die Greifeinrichtung eine Folie 12 aufgenommen hat. Dazu wurden die Vakuumgreifer 20 abgesenkt, bis sie die oberste Folie 12 des Stapels 10 berühren. Durch Anlegen von Vakuum wird im Idealfall einer einzelnen Folie 12 abgehoben. Der in dem induktiven Foliendetektor vorgesehene Schwingkreis wird durch die Anwesenheit der metallischen Beschichtung der Folie 12 in beschriebener Weise bedämpft, so dass die Anwesenheit einer Folie detektiert werden kann.

Grundsätzlich kann es aber auch passieren, dass z.B. zwei Folien aneinanderhaften, so dass zwei Folien 12 gleichzeitig aufgegriffen werden. Das Bedämpfungssignal des Schwingkreises ist dann anders, als wenn nur eine Folie vorliegt. Insbesondere ist das Bedämpfungssignal beim Vorhandensein von zwei Folien geringer als von nur einer Folie.

In dem induktiven Foliendetektor 30 befindet sich ein Schwingkreis, dessen Bedämpfung in an sich bekannter Weise gemessen wird. Das Bedämpfungssignal wird von der Auswerteeinrichtung ausgewertet, indem es mit einem ersten Schwellwert verglichen wird, dessen Überschreiten die Präsenz von nur einer Folie bedeutet, wohingegen dessen Unterschreiten die Präsenz von zwei Folien bzw. die Präsenz von gar keiner Folie bedeutet, wenn ein sehr geringer Schwellwert unterschritten wird. Am Ausgang der Auswerteeinrichtung 40 wird ein entsprechendes digitales Signal ausgegeben, das z.B. in einer SPS weiterverarbeitet wird. Dieses digitale Signal kann also drei Werte annehmen.

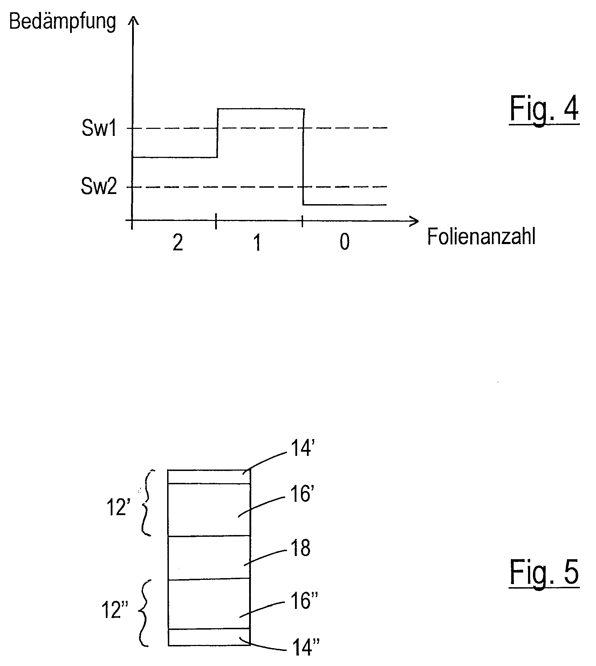

In Fig. 4 ist dargestellt, wie die Bedämpfung beispielsweise von der Folienanzahl abhängen kann. Ist keine Folie am Vakuumgreifer, so ist das Bedämpfungssignal sehr gering und der Schwingkreis schwingt nahezu ungedämpft. Ist eine Folie am Vakuumgreifer, so ist eine relativ hohe Bedämpfung festzustellen. Sind zwei Folien am Greifer, so ist das Bedämpfungssignal wiederum geringer.

Fig. 4 zeigt die Bedämpfung in beliebigen Einheiten in Abhängigkeit der Folienanzahl. Der Detektionsabstand des induktiven Foliendetektors ergibt sich bei der genannten Anwendung aus dem Abstand des Foliensensors 30 von einer gegriffenen Folie 12, wenn sie sich am Vakuumgreifer befindet.

Grundsätzlich ist es auch möglich, dass der erste und der zweite Schwellwert gleich sind und nur dieser eine Schwellwert abgeprüft wird. Auf diese Weise ist es möglich, zu entscheiden, ob eine Folie gegriffen worden ist. Ob zwei oder gar keine Folie gegriffen worden sind, ist dann nicht zu unterscheiden.

Fig. 5 zeigt beispielhaft und nur zur Erläuterung den Lagenaufbau eines Akkumulators, der hier anhand des Beispiels eines Lithium-Ionen-Akkus erläutert wird. Die Kathode 16' dient zur Aufnahme von Li+-Ionen und besteht z.B. aus LiFeMnPO4. Auf der Kathode 16' befindet sich als Elektrode eine elektrisch leitende Aluminiumfolie 14'. Andererseits umfasst die Anode 16" ein Material zur Abgabe der Li+-Ionen beim Entladen. Es besteht z.B. aus künstlichem Graphitpulver. Als Elektrode dient eine elektrisch leitende Kupferfolie 14". Zwischen Anode und Kathode befindet sich ein Elektrolyt bzw. Separator 18, der für Li+-Ionen durchlässig aber ansonsten elektrisch isolierend ist. Die Dicken der metallischen Schichten 14' bzw. 14" betragen bei dem beschriebenen Beispiel z.B. in der Größenordnung von 20 bis 30 µm. Die Kathoden bzw. Anodenschichten 16', 16" können je nach Anwendung und Ausgestaltung z.B. 20 bis 40 µm oder auch bis zu 200 µm dick sein.

Der erfindungsgemäße induktive Foliendetektor dient dazu, die Anzahl von von einem Stapel 10 gegriffenen Folien 12 zu bestimmen, die aus metallischen Schichten 14' bzw. 14" und den Kathoden- bzw. Anodenschichten 16', 16" bestehen.

### Bezugszeichenliste

- 10: Folienstapel
- 12: Folie
- 14: elektrisch leitfähige Schicht
- 16: Grundmaterial
- 12': Kathodenfolie
- 12": Anodenfolie
- 14': Aluminiumschicht
- 14": Kupferschicht
- 16': Kathodenschicht
- 16": Anodenschicht
- 18: Separator, Elektrolyt
- 20: Greifer
- 30: induktiver Foliendetektor
- 40: Auswerteeinrichtung

- SW1: erster Schwellwert
- SW2: zweiter Schwellwert

## Patentansprüche

1. Induktiver Foliendetektor (30) zur Detektion der Anzahl von aneinander liegenden Folien (12), die jeweils ein insbesondere nicht oder schlecht leitendes Grundmaterial (16) und eine daran angeordnete, elektrisch leitfähige Schicht (14) umfassen, mit
- einem Schwingkreis zur Erzeugung eines elektromagnetischen Wechselfeldes, wobei die elektrisch leitfähige Schicht eine derart geringe Materialstärke aufweist, dass das Wechselfeld die Folie durchdringen kann, und
- einer Auswerteeinrichtung (40) zur Bestimmung der Bedämpfung des Schwingkreises, wobei entweder
(i) die Auswerteeinrichtung (40) derart ausgestaltet ist, dass sie bei Überschreiten eines ersten vorgegebenen Schwellwertes (SW1) der Bedämpfung vom Vorhandensein einer einzelnen Folie (12) in einem vorgegebenen Detektionsabstand, bei Unterschreiten des ersten Schwellwertes (SW1) vom Vorhandensein wenigstens zweier Folien (12) im vorgegebenen Detektionsabstand und bei Unterschreiten eines zweiten vorgegebenen Schwellwertes (SW2), der kleiner als der erste Schwellwert (SW1) ist, von einem Zustand ohne Folie im Detektionsabstand ausgeht, oder
(ii) der zweite Schwellwert gleich dem ersten Schwellwert ist und die Auswerteeinheit (40) derart ausgestaltet ist, dass sie bei Überschreiten des Schwellwertes vom Vorhandensein genau einer Folie (12) im Detektionsabstand und beim Unterschreiten des Schwellwertes vom Vorliegen gar keiner oder von zwei oder mehr Folien (12) im Detektionsabstand ausgeht.

2. Induktiver Foliendetektor nach Anspruch 1, bei dem die Auswerteeinrichtung (40) derart ausgestaltet ist, dass sie ein Signal an einen Digitalausgang gibt, dessen Größe vom Über- bzw. Unterschreiten des ersten und/oder des zweiten Schwellwertes (SW1, SW2) abhängt.

3. Induktiver Foliendetektor nach einem der Ansprüche 1 oder 2, mit einer Speichereinrichtung, in dem eingelernte Schwellwerte (SW1, SW2) abgelegt sind, die in Abhängigkeit der zu detektierenden Folien (12) in einem Teach-In-Prozess bestimmt wurden.

4. Greifeinrichtung (20) für Folien (12) von einem Stapel (10), insbesondere von Anoden- und/oder Kathodenfolien (12', 12") zum Einsatz in Akkumulatoren, mit einem induktiven Foliendetektor (30) nach einem der Ansprüche 1 bis 3, der derart an der Greifeinrichtung (20) angeordnet ist, dass er die Anzahl der von dem Greifer gehaltenen Folien (12) bestimmen kann.

5. Verfahren zur Bestimmung ob (a) eine, (b) zwei oder mehr, oder (c) keine aneinander liegenden Folien (12) in einem Detektionsabstand vorliegen, die jeweils ein Grundmaterial (16) und eine daran angeordnete, elektrisch leitfähige Schicht (14) umfassen, insbesondere von Anoden- und/oder Kathodenfolien (12', 12") zum Einsatz in Akkumulatoren, bei dem die unbekannte Folienanzahl in einen Detektionsabstand gebracht wird, mit einem Schwingkreis ein elektromagnetisches Wechselfeld erzeugt wird, wobei die elektrisch leitfähige Schicht der Folien eine derart geringe Materialstärke aufweist, dass das Wechselfeld die Folie durchdringen kann, und aus der Bedämpfung des Schwingkreises auf die Anzahl von Folien (12) in dem vorgegebenen Detektionsabstand geschlossen wird, wobei
i) bei Überschreiten eines ersten vorgegebenen Schwellwertes (SW1) der Bedämpfung vom Vorhandensein genau einer Folie (12) in einem vorgegebenen Detektionsabstand ausgegangen wird, bei Unterschreiten des ersten Schwellwertes (SW1) vom Vorhandensein wenigstens zweier Folien (12) im vorgegebenen Detektionsabstand und bei Unterschreiten eines zweiten vorgegebenen Schwellwertes (SW2), der kleiner als der erste Schwellwert (SW1) ist, von einem Zustand ohne Folie im Detektionsabstand ausgegangen wird, oder
ii) der zweite Schwellwert gleich dem ersten Schwellwert ist und bei Überschreiten des Schwellwertes vom Vorhandensein genau einer Folie (12) im Detektionsabstand und bei Unterschreiten des ersten Schwellwerts vom Vorliegen gar keiner oder von zwei oder mehr Folien (12) im Detektionsabstand ausgegangen wird.

6. Verfahren nach einem der Anspruch 5, bei dem der Schwellwert oder die Schwellwerte im Vorhinein eingelernt wird/werden.

## Claims

1. An inductive foil detector (30) for detecting the number of mutually following foils (12) which each comprise a base material (16), which is in particular non-conductive or weakly conductive, and an electrically conductive layer (24) arranged thereat, comprising
- a resonant circuit for generating an alternating electromagnetic field, wherein the electrically conductive layer has such a small material thickness that the alternating field can penetrate the foil; and
- an evaluation device (40) for determining the damping of the resonant circuit, wherein either
(i) the evaluation device (40) is configured such that it assumes the presence of an individual foil (12) at a predefined detection spacing on an exceeding of a first predefined threshold value (SW1) of the damping; such that it assumes the presence of at least two foils (12) at the predefined detection spacing on a falling below of the first threshold value (SW1); and such that it assumes a state without a foil at the detection spacing on the falling below of a second predefined threshold value (SW2) which is smaller than the first threshold value (SW1); or
(ii) the second threshold value is the same as the first threshold value and the evaluation unit (40) is configured such that it assumes the presence of exactly one foil (12) at the detection spacing on an exceeding of the threshold value; and such that it assumes the presence of no foil at all or of two or more foils (12) at the detection spacing on the falling below of the threshold value.

2. An inductive foil detector in accordance with claim 1, in which the evaluation device (40) is configured such that it outputs a signal to a digital output whose magnitude depends on the exceeding or falling below of the first and/or of the second threshold value (SW1/SW2).

3. An inductive foil detector in accordance with one of the claims 1 or 2, comprising a memory device in which taught threshold values (SW1, SW2) are stored which were determined in a teach-in process in dependence on the foils (12) to be detected.

4. A gripping device (20) for foils (12) from a stack (10), in particular of anode and/or cathode foils (12', 12") for use in storage batteries, comprising an inductive foil detector (30) in accordance with any one of the claims 1 to 3, which is arranged at the gripping device (20) such that it can determine the number of foils (12) held by the gripper.

5. A method of determining whether (a) one, (b) two or more, or (c) no mutually contacting foils (12) are present at a detection spacing which each comprise a base material (16) and an electrically conductive layer (14), in particular of anode and/or cathode foils (12', 12") arranged thereat, for use in accumulators, in which the unknown number of foils are brought into a detection spacing; in which an alternating electromagnetic field is produced by a resonant circuit, with the electrically conductive layer of the foils having such a small material thickness that the alternating field can penetrate the foil and a conclusion is drawn from the damping of the resonant circuit on the number of foils (12) at the predefined detection spacing, wherein
i) the presence of exactly one individual foil (12) at a predefined spacing is assumed on an exceeding of a first predefined threshold value (SW1) of the damping; the presence of at least two foils (12) at the predefined detection spacing is assumed on a falling below of the first threshold value (SW1); and a state without a foil at the detection spacing is assumed on the falling below of a second predefined threshold value (SW2) which is smaller than the first threshold value; or
ii) the second threshold value is the same as the first threshold value and the presence of exactly one foil (12) at the detection spacing is assumed on a falling below of the threshold value; and the presence of no foil or of two or more foils (12) at the detection spacing is assumed on the falling below of the first threshold value.

6. A method in accordance with claim 5, in which the threshold value or the threshold values is/are taught in advance.

## Revendications

1. Détecteur inductif de feuille (30) destiné à la détection du nombre de feuilles (12) superposées qui comprennent chacune un matériau de base (16) en particulier non conducteur ou mauvais conducteur et une couche (14) électriquement conductrice agencée sur celui-ci, comportant
- un circuit oscillant destiné à générer un champ alternatif électromagnétique, la couche électriquement conductrice présentant une épaisseur si faible que le champ alternatif est capable de traverser la feuille, et
- un dispositif d'évaluation (40) destiné à déterminer l'amortissement du circuit oscillant, dans lequel soit
(i) le dispositif d'évaluation (40) est réalisé de manière à supposer la présence d'une feuille individuelle (12) à une distance de détection prédéterminée lors d'un dépassement d'une première valeur seuil prédéterminée (SW1) de l'amortissement, à supposer la présence d'au moins deux feuilles (12) à la distance de détection prédéterminée lors du passage au-dessous de la première valeur seuil (SW1), et à supposer un état dépourvu de feuille à la distance de détection lors d'un passage au-dessous d'une seconde valeur seuil prédéterminée (SW2) inférieure à la première valeur seuil (SW1), soit
(ii) la seconde valeur seuil est égale à la première valeur seuil et l'unité d'évaluation (40) est réalisée de manière à supposer la présence de précisément une feuille (12) à la distance de détection lors du dépassement de la valeur seuil et à supposer la présence d'aucune ou de deux ou plusieurs feuilles (12) à la distance de détection lors du passage au-dessous de la valeur seuil.

2. Détecteur inductif de feuille selon la revendication 1, dans lequel le dispositif d'évaluation (40) est réalisé de manière à émettre un signal vers une sortie numérique, dont la taille dépend du dépassement ou du passage au-dessous de la première et/ou de la seconde valeur seuil (SW1, SW2).

3. Détecteur inductif de feuille selon l'une des revendications 1 ou 2, comportant un dispositif de mémorisation dans lequel sont stockées des valeurs seuil (SW1, SW2) apprises qui ont été déterminées par un processus d'apprentissage en fonction des feuilles à détecter (12).

4. Dispositif de préhension (20) pour des feuilles (12) à partir d'une pile (10), en particulier des feuilles anodiques et/ou cathodiques (12', 12") destinées à être mises en place dans des accumulateurs, comportant un détecteur inductif de feuille (30) selon l'une des revendications 1 à 3, qui est agencé sur le dispositif de préhension (20) de manière à pouvoir déterminer le nombre de feuilles (12) retenues par le préhenseur.

5. Procédé pour déterminer si (a) une, (b) deux ou plusieurs, ou (c) aucune feuilles (12) superposées se présente(nt) à une distance de détection, qui incluent chacune un matériau de base (16) et une couche (14) électriquement conductrice agencée sur celui-ci, en particulier des feuilles anodiques et/ou cathodiques (12', 12") destinées à être mises en place dans des accumulateurs, dans lequel on amène le nombre inconnu de feuilles à une distance de détection, on génère un champ alternatif électromagnétique au moyen d'un circuit oscillant, la couche électriquement conductrice des feuilles présentant une épaisseur si faible que le champ alternatif est capable de traverser la feuille, et on conclut quant au nombre de feuilles (12) à la distance de détection prédéterminée à partir de l'amortissement du circuit oscillant, et
i) lors du dépassement d'une première valeur seuil prédéterminée (SW1) de l'amortissement, on suppose la présence de précisément une feuille (12) à une distance de détection prédéterminée, lors du passage au dessous de la première valeur seuil (SW1) on suppose la présence d'au moins deux feuilles (12) à la distance de détection prédéterminée, et lors du passage au-dessous d'une seconde valeur seuil prédéterminée (SW2) inférieure à la première valeur seuil (SW1) on suppose un état dépourvu de feuille à la distance de détection, ou
ii) la seconde valeur seuil est égale à la première valeur seuil et lors d'un dépassement de la valeur seuil on suppose la présence de précisément une feuille (12) à la distance de détection, et lors du passage au-dessous de la première valeur seuil on suppose la présence d'aucune ou de deux ou plusieurs feuilles (12) à la distance de détection.

6. Procédé selon la revendication 5, dans lequel on apprend au préalable la valeur seuil ou les valeurs seuils.
